# EUROPÄISCHE PATENTSCHRIFT

(11) **EP 1 332 505 B1**
(45) Veröffentlichungstag und Bekanntmachung des Hinweises auf die Patenterteilung: **04.05.2005**
(21) Anmeldenummer: 01993010.6
(22) Anmeldetag: 02.11.2001
(51) Int. Cl.: H01H 13/02, H01H 9/16, H03K 17/96

(54) **ELEKTRISCHER SCHALTER, INSBESONDERE PIEZOSCHALTER, MIT OPTISCHER UND/ODER MECHANISCHER RÜCKMELDUNG DES SCHALTVORGANGES**
ELECTRIC SWITCH, ESPECIALLY A PIEZO SWITCH, WITH OPTICAL AND/OR MECHANICAL FEEDBACK OF THE SWITCHING OPERATION
INTERRUPTEUR ELECTRIQUE, NOTAMMENT INTERRUPTEUR PIEZO-ELECTRIQUE, AVEC ACCUSE RECEPTION OPTIQUE ET/OU MECANIQUE DU PROCESSUS DE COMMUTATION

(30) Priorität: 06.11.2000 DE 10054862
(43) Veröffentlichungstag der Anmeldung: 06.08.2003
(73) Patentinhaber: Dyna Systems GmbH, 88161 Lindenberg (DE); DEMMEL AG, 88175 Scheidegg (DE)
(72) Erfinder: STADELMANN, Mathias, 88178 Heimenkirch (DE)
(74) Vertreter: Riebling, Peter, Dr.-Ing.
(86) Internationale Anmeldenummer: PCT/EP2001/012690
(87) Internationale Veröffentlichungsnummer: WO 2002/037516

(56) Entgegenhaltungen:
- EP-A- 0 538 199
- DE-A- 19 528 821
- DE-U- 9 105 230
- DE-U- 9 312 587
- DE-U- 29 510 010

## Beschreibung

Die Erfindung betrifft einen elektrischen Schalter, insbesondere Piezoschalter, mit optischer und/oder mechanischer Rückmeldung des Schaltvorganges nach dem Oberbegriff des unabhängigen Patentanspruchs 1. Die Erfindung soll ausdrücklich nicht ausschließlich auf Piezoschalter bezogen sein, sondern es sollen sämtliche Funktionsprinzipien eines elektrischen Schalters mit der Erfindung abgedeckt sein und somit unter Schutz gestellt werden. Im Folgenden wird nur noch Bezug genommen auf den bevorzugten Anwendungsfall eines Piezoschalters.

Ein derartiger Piezoschalter ist beispielsweise aus dem Gegenstand der DE 19528821 bekannt geworden, bei dem in einem Gehäuse ein Piezo-Element angeordnet ist, welches von oben von einem Betätiger betätigt wird, der mit seiner Betätigungsfläche durch einen Ausschnitt in einem Deckformteil hindurchgreift. Als Betätigungsfläche ist eine runde, relativ ebene Fläche vorgesehen, und der gesamte Betätiger ist beleuchtet.

Mit der DE 197 04 253 A1 ist eine Bedieneinheit für KfZ-Komponenten bekannt geworden mit einem bewegbaren Bedienelement, an dessen Vorderwandabschnitt ein zumindest teilweise lichtdurchlässiges Symbolfeld angeordnet ist, wobei unter dem Vorderwandabschnitt des Bedienelements sich ein Lichtleitelement befindet, das auf ein Schaltorgan des Schalters zu dessen Betätigung wirkt, wenn das Bedienelement nach unten bewegt wird. Das Symbolfeld wird durch ein Lichtelement über das Lichtleitelement mittelbar beleuchtet, wobei das Lichtelement sich unter dem Lichtieitelement befindet. Das Lichtleitelement hat eine schräge Fläche für den Lichteintritt, was eine außermittige Lage des Lichtelement erlaubt auf Grund der zentralen Lage des Schalters.

Nachteil hierbei ist, dass zur Betätigung des Schalters mehrere verschiedene, aufwändig herzustellende und mindestens teilweise transparente Elemente (Bedienelement mit Symbolfeld und Lichtleitelement mit Schrägflächen) vorgesehen sein müssen, was zu erhöhten Material- und Montagekosten, als auch zu einer geringeren Lichtausbeute durch Lichtabsorption, insbesondere an den Übergängen der verschieden Elemente führt. Eine optische und/oder mechanische Rückmeldung des Schaltvorganges ist in dieser DE 197 04 253 A1 nicht offenbart.

Der Erfindung liegt die Aufgabe zugrunde, einen insbesondere piezoelektrischen Schalter der eingangs genannten Art so weiterzubilden, daß eine optische und/oder mechanische Rückmeldung des Schaltvorganges in besonders auffälliger Weise erfolgt.

Zur Lösung der gestellten Aufgabe ist die Erfindung durch die technische Lehre des unabhängigen Patentanspruch 1 gekennzeichnet.

Wesentliches Merkmal der Erfindung ist, daß das Betätigungselement selbst als passiver Leuchtkörper aus einem mindestens transluzenten Material ausgebildet ist, wobei der passive Leuchtkörper über aktive Leuchtmittel beleuchtbar ist.

Mit der gegebenen technischen Lehre ergibt sich der wesentliche Vorteil, daß nun insgesamt der Betätiger des insbesondere piezoelektrischen Schalters als Leuchtkörper ausgebildet ist, der bevorzugt aus einem transluzenten Kunststoffmaterial besteht.

Ein derartiges Kunststoffmaterial sollte also mindestens teilweise lichtdurchlässig ausgebildet sein; es kann aber völlig transparent ausgebildet sein.

Es kann sich hier um einen einschichtigen oder einen mehrschichtigen Leuchtkörper handeln, so daß bei dessen rückseitiger Beleuchtung das Licht insgesamt in dem als Betätiger ausgebildeten Leuchtkörper gleichmäßig verteilt wird.

Wenn nun die Betätigungsfläche (d. h. also, die nächst dem Benutzer liegende, zu drückende Fläche des Schalters) als Symbolkörper ausgebildet ist, leuchtet der Symbolkörper besonders intensiv.

Eine besonders eindrucksvolle Leuchterscheinung ergibt sich dann, wenn der Symbolkörper aus der Vorderfläche des Leuchtkörpers dreidimensional herausgefräst ist, so daß man lediglich auf den Symbolkörper drückt, um den als Betätiger ausgebildeten Leuchtkörper zu betätigen, der seinerseits das Schaltelement im Schalter betätigt.

Damit ergibt sich erstmals der Vorteil, daß man kein Betätigungsgehäuse für einen Leuchtkörper mehr hat, wie es beispielsweise in DE 31 33 134 A1 gelehrt wird.

Dort ist Voraussetzung, daß in einem etwa kolbenförmigen, undurchsichtigen Gehäuse frontseitig eine durchsichtige Kunststoffscheibe eingesetzt wird, die rückwärtig von einem oder mehreren LEDs beleuchtet wird.

Dies bedingt einen raumgreifenden Aufbau und keine besonders eindrucksvolle Beleuchtung der Betätigungsfläche, weil die Betätigungsfläche relativ klein ausgebildet ist.

Hier setzt die Erfindung ein, die vorsieht, daß insgesamt der Betätigungskörper als Leuchtkörper ausgebildet ist, an dessen Vorderseite der Symbolkörper bevorzugt als dreidimensionaler Körper herausgefräst ist.

Diese dreidimensionale Ausbildung des Symbolkörpers des Leuchtkörpers kann in zwei verschiedenen Ausführungsformen verwirklicht werden.

Zunächst kann in der ersten Ausführungsform die Durchbrechung in der Deckplatte, durch welche der Leuchtkörper hindurchgreift, völlig ausgenommen sein, so daß also der dreidimensionale Symbolkörper, zusammen mit den übrigen Teilen des Leuchtkörpers, vollflächig durch beispielsweise eine zylindrische Durchbrechung in der Deckplatte hindurchgreift.

Es wäre dann sowohl der Symbolkörper beleuchtet als auch dessen Umgebungsbereich im Leuchtkörper selbst.

In der erfindungsgemäßen Ausführungsform kann es vorgesehen sein, daß nur der Symbolkörper durch eine entsprechend formschlüssig angepaßte Durchbrechung in der Deckplatte hindurchgreift und daß die übrigen Teile des Leuchtkörpers von den Stegen der Ausfräsung und Durchbrechung in der Deckplatte verdeckt sind, so daß in diesem Fall nur der dreidimensionale Symbolkörper selbst durch die Durchbrechungen in der Deckplatte hindurchragt und nur der Symbolkörper selbst dann auch von außen her beleuchtet erscheint.

Im ersten Fall wird also insgesamt die Stirnfläche des Leuchtkörpers mit dem darauf angeformten Symbolkörper beleuchtet, während im zweiten Fall nur noch der Symbolkörper selbst als beleuchtetes Element durch entsprechende Durchbrechungen in der Deckplatte hindurchgreift und damit gleichzeitig als Betätigungselement wirkt.

Weil man nur den dreidimensional herausgefrästen Symbolkörper von vorne her von der Deckplatte aus sieht, dient dieser Symbolkörper gleichzeitig als Betätigungsfläche für den Schalter. Dieser Symbolkörper ist erfindungsgemäß beleuchtet. Damit ergibt sich der Vorteil, daß neben dem optisch eindrucksvollen Aussehen der Betätigungsfläche, die lediglich durch den Symbolkörper selbst charakterisiert wird, gleichzeitig auch ein Ertasten des Symbolkörpers (ohne visuelle Hilfe) möglich ist.

In der Art eines Braille-Symbols können mit einem derartigen beleuchteten Schalter mehrere beleuchtete Braille-Symbole bewerkstelligt werden, die also sehr gut als Betätigungsfläche taktil erfaßbar und durch entsprechenden Fingerdruck betätigbar sind.

Für die taktile Rückmeldung der Betätigung des Leuchtkörpers gibt es unterschiedliche Ausführungsformen, die alle von dem Erfindungsgedanken der vorliegenden Erfindung umfaßt sein sollen. Diese Ausführungsformen sollen jeweils einzeln für sich, aber auch in Kombination untereinander, Schutz genießen.

In einer ersten Ausführungsform ist es vorgesehen, daß der als Betätigungselement ausgebildete Leuchtkörper auf eine Schnappfeder wirkt und die Schnappfeder ihrerseits auf dem Piezo-Element aufsitzt, so daß bei Betätigung des Symbolkörpers zunächst der Leuchtkörper um einen Schaltweg von z. B. 0,3 mm in das Gehäuse des Schalters hineinbewegt wird, bis das Piezo-Element durch die Schnappfeder betätigt wird und das entsprechende Signal abgibt.

In einer zweiten Ausgestaltung der Erfindung ist es vorgesehen, daß eine derartige Schnappfeder entfällt und daß statt dessen das Betätigungselement (ausgebildet als Vollmaterial-Leuchtkörper) unmittelbar auf dem Piezosensor aufsitzt. In diesem Fall erfolgt keine taktile Rückmeldung des Schaltvorganges an den Benutzer, weil der Leuchtkörper lediglich um einen Schaltweg von z. B. 4 µm bewegt werden muß, um ein entsprechendes elektrisches Signal am Piezosensor zu erzeugen.

Allerdings kann bei allen Schaltervarianten eine optische Rückmeldung erfolgen, z. B. in der Weise, daß die Beleuchtung auf den Symbolkörper in Richtung auf eine andere Farbe geändert wird oder ein- oder ausgeschaltet wird.

Wichtig bei allen Ausführungsformen ist also die vollflächige Beleuchtung des Leuchtkörpers, der selbst als Betätigungselement ausgebildet ist.

Zu diesem Zweck sind an der Rückseite des Leuchtkörpers - im Innenraum des Schaltergehäuses - mehrere LEDs verteilt am Umfang angeordnet, wobei bevorzugt LEDs einer einzigen Farbe verwendet werden, welche die Rückseite des Leuchtkörpers vollflächig beleuchten.

Aufgrund der Leuchtverteilung im Leuchtkörper wird dieser damit über sein gesamtes Volumen gleichmäßig beleuchtet und die Leuchtdichte wird sehr gleichmäßig auf den an der Vorderseite angeordneten Symbolkörper übertragen.

Selbstverständlich ist es möglich, auch verschiedenfarbige LEDs anzuordnen, um beispielsweise bei dem einen Schaltvorgang eine grüne Farbe des Leuchtkörpers als Beleuchtungsfarbe zu erzeugen und bei der Änderung des Schaltvorganges die blau oder rot leuchtenden LEDs einzuschalten, um den Leuchtkörper dann in der genannten Farbe leuchten zu lassen.

In einer dritten Ausgestaltung der vorliegenden Erfindung ist eine motorische Rückmeldung des Schaltvorganges an den Benutzer vorgesehen.

Für diesen Fall ist vorgesehen, daß am Schaltergehäuse oder im Schaltergehäuse ein Vibrator angeordnet ist, der aufgrund des eingeleiteten Schaltvorganges betätigt wird und der eine vibrierende Bewegung auf den Leuchtkörper (damit den Betätiger) abgibt, so daß der Betätiger mechanisch vibriert, wenn der Schaltvorgang ausgelöst wird.

Für die Ausbildung dieses Vibrators gibt es eine Reihe von Möglichkeiten, die alle von der Erfindung umfaßt sein sollen.

In einer ersten Ausgestaltung soll vorgesehen sein, daß der Vibrator als Miniaturmotor ausgebildet ist, der eine Scheibe antreibt, auf der ein exzentrisch gelagertes Exzentergewicht angeordnet ist.

Mit der Einschaltung dieses Motors wird damit das Exzentergewicht an der Scheibe eine entsprechende Unwucht erzeugen, und diese Unwucht wird über das Motorlager und die Motorhalterung des Motors an dem Gehäuse des Schalters auf den, als Betätiger ausgebildeten, Leuchtkörper weitergeleitet.

Das Exzentergewicht kann in einer anderen Ausführung natürlich entfallen und die exzentrisch gelagerte Scheibe selbst bildet dann die Unwucht.

In einer anderen Ausgestaltung der Erfindung kann vorgesehen sein, daß der Vibrator als Wagner'scher Hammer ausgebildet ist, d. h. in der Art einer Klingel, während abwechselnd zwei verschiedene Kontakte geschaltet werden, die auch vibrieren und diese Vibrationsbewegung ebenfalls auf den Leuchtkörper übertragen.

Ebenso kann selbstverständlich ein Elektromagnet oder ein Ultraschall-Element verwendet werden, welches eine entsprechende Vibration, auch im Fühlbereich des Menschen, abgeben kann.

In einer dritten Ausgestaltung kann es vorgesehen sein, daß der Piezosensor auch als aktives Vibrationselement verwendet wird. In diesem Fall wird das Piezokristall durch eine geschaltete, von außen angelegte, Spannung in Schwingungen versetzt, und diese Schwingungen werden unmittelbar auf den Leuchtkörper übertragen, weil dieser mit einem entsprechenden Betätigungsansatz unmittelbar bzw. über die Federscheibe indirekt - auf dem Piezokristall - aufsitzt.

Genausogut kann ein zweites Piezo-Element verwendet werden, welches kraftschlüssig mit dem Leuchtkörper verbunden ist, welches lediglich bei Einschaltung des Schaltvorganges für eine Dauer von z. B. 120 ms die genannte Vibrationsbewegung auf den Leuchtkörper ausübt.

Selbstverständlich soll die Rückmeldung des Schaltvorganges über die genannten Vibratoren auch unabhängig von der vorher genannten Beleuchtung funktionieren.

D. h., der Schutzbereich der vorliegenden Erfindung bezieht sich also auch auf einen Schalter mit einem unbeleuchteten Leuchtkörper, an dessen Gehäuse ein Vibrator angeordnet ist, der bei Auslösung des Schaltvorganges für eine bestimmte Zeit von z. B. 120 ms eine taktile Rückmeldung in Form einer Vibration auf den Betätiger ausübt.

Im folgenden wird die Erfindung anhand von mehreren Zeichnungen näher erläutert, welche mehrere Ausführungswege darstellen. Hierbei gehen aus den Zeichnungen und ihrer Beschreibung weitere Merkmale und Vorteile der Erfindung hervor.

Es zeigen:
- Fig. 1:: schematisiert eine Explosionsdarstellung im Schnitt einer ersten Ausführungsform eines Piezöschalters;
- Fig. 1a:: schematisiert eine Explosionsdarstellung im Schnitt einer weiteren Ausführungsform eines Piezoschalters ohne Druckstück des Betätigungselementes;
- Fig. 2:: eine vergrößerte Darstellung des Piezosensors gemäß Figur 1;
- Fig. 3:: die Draufsicht auf die Stirnseite des Gehäuses des Schalters;
- Fig. 4:: die Draufsicht auf die Stirnseite des die Ausnehmung in der Deckplatte durchbrechenden Symbolkörpers;
- Fig. 5:: die Draufsicht auf die Platine mit den LEDs nach Figur 1;
- Fig. 6:: die Draufsicht auf die Schnappfeder nach Figur 1;
- Fig. 7:: die Ausführung nach Figur 1 im zusammengebauten Zustand mit einer geringfügigen Abwandlung im Bereich der Deckplatte;
- Fig. 8:: die Draufsicht auf die Stirnseite der Ausführung nach Figur 7;
- Fig.9:: eine gegenüber Figur 7 abgewandelte Ausführungsform mit einer geringfügigen Abwandlung im Bereich der Deckplatte und unter Weglassung der Schnappfeder;
- Fig. 10:: die Draufsicht auf die Stirnseite der Anordnung nach Figur 9;
- Fig. 11:: der schematisierte Schnitt durch eine gegenüber Figur 7 abgewandelte weitere Ausführungsform mit einer geringfügigen Abwandlung im Bereich der Deckplatte und mit mechanischer Rückmeldung des Schaltvorganges;
- Fig. 12:: die Draufsicht auf die Stirnseite der Ausführung nach Figur 11;
- Fig. 13:: den Schalter gemäß Figur 11 mit einer anderen Ausführung des Vibrators und der Halterung des Vibrators an dem Motorlager;
- Fig. 14:: den Vibrator gemäß Figur 13 in Seitenansicht.

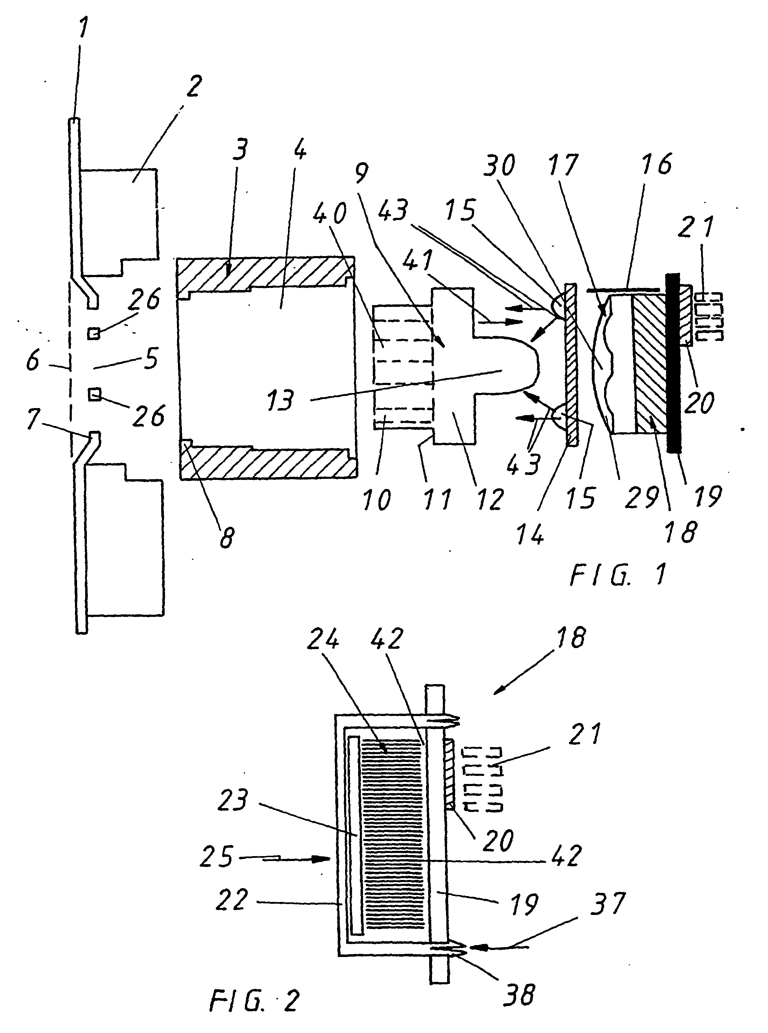

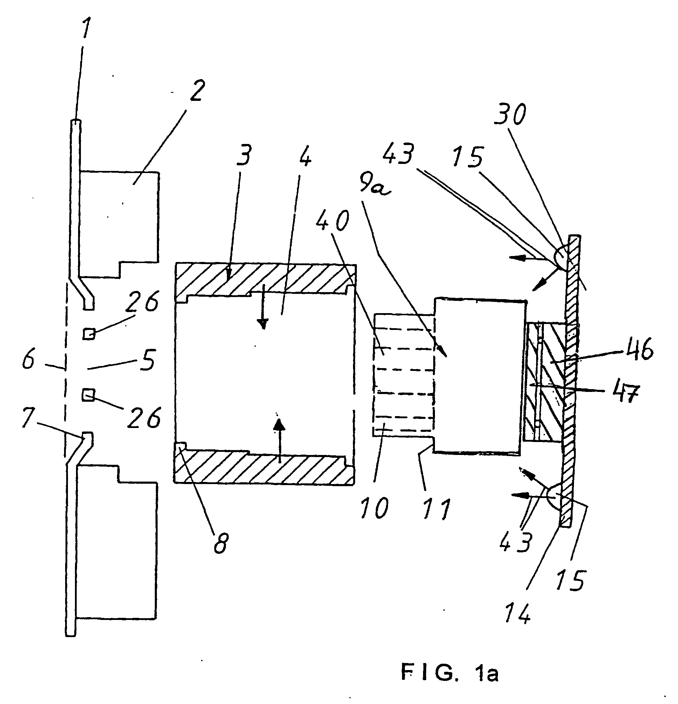

Der erfindungsgemäße Piezoschalter sitzt gemäß Figur 1 hinter einer Deckplatte 1, die aus einem beliebigen Material geformt sein kann, z. B. aus Holz, Metall, Glas oder Kunststoff. Die Deckplatte 1 kann in beliebiger Weise geformt sein.

Zur mechanischen Stabilisierung der Deckplatte kann diese mit einem Träger 2 hinterlegt sein, der beispielsweise aus einem Kunststoffmaterial besteht. Der Träger 2 kann hierbei an der Deckplatte 1 angeklebt sein. Er kann aber auch werkstoffeinstückig mit der Deckplatte 1 verbunden sein.

Ebenso kann der Träger 2 mechanisch an die Deckplatte 1 angeklemmt werden, wobei entsprechende Klemmhalterungen vorhanden sind, die nicht näher dargestellt sind.

In der Deckplatte 1 ist ein Ausschnitt 5 angeordnet, wobei der Ausschnitt 5 von der frontseitigen Vorderfläche 6 zurückversetzt ist und einen Rückversatz 7 bildet.

Am Träger 2 ist das Gehäuse 3 eines Piezoschalters befestigt, wobei beliebige Befestigungsmittel verwendet werden können. Das Gehäuse kann hierbei geklemmt, geklebt, geschraubt oder in anderer Weise fest oder lösbar mit dem Träger 2 verbunden sein.

Das Gehäuse 3 besteht im wesentlichen aus einem Hohlzylinder, der einen inneren, zylindrischen Hohlraum 4 aufweist, der mehrere Abstufungen aufweist.

In der Nähe der vorderen Stirnseite ist ein Ringanschlag 8 ausgebildet, welcher für den Bewegungsanschlag des als Betätigungselement ausgebildeten Leuchtkörpers 9 dient.

Allgemein wird in bezug auf das hier beschriebene Ausführungsbeispiel, aber auch in bezug auf alle anderen Ausführungsbeispiele, bei den Figuren 1 bis 12 angemerkt, daß die Formgebung des gesamten Schalters in einem großen Bereich geändert werden kann. Es ist zwar in den Ausführungsbeispielen dargestellt, daß die Elemente des Schalters (Gehäuse 3, Leuchtkörper 9 und alle anderen Teile, wie z. B. die Platinen 14 und 19) als kreisförmige Teile ausgebildet sind. Hierauf ist die Erfindung jedoch nicht beschränkt. Es können die genannten Teile auch in beliebiger anderer Querschnittsform gebildet sein, wie z. B. elliptisch, dreieckig, sechseckig, achteckig, quadratisch und dergleichen mehr.

Die Darstellung der genannten Teile als zylinderförmige, im Querschnitt kreisförmige Teile ist deshalb nur beispielhaft zu verstehen.

Wichtig ist, daß der Leuchtkörper 9 nun als Betätigungselement, z. B. aus einem transluzenten Kunststoffmaterial, ausgebildet ist und einen vorderen Symbolkörper 10 aufweist, der dreidimensional geformt ist.

Die Formgebung erfolgt in der Weise, daß lediglich die die Formgebung des Symbols definierenden Symbolstege 40 durch die entsprechenden Durchbrechungen im Bereich des Ausschnittes 5 der Deckplatte 1 hindurchgreifen und die übrigen Teile des Symbolkörpers durch die im Bereich des Ausschnittes 5 angeordneten Stege 26 der Deckplatte 1 verdeckt sind.

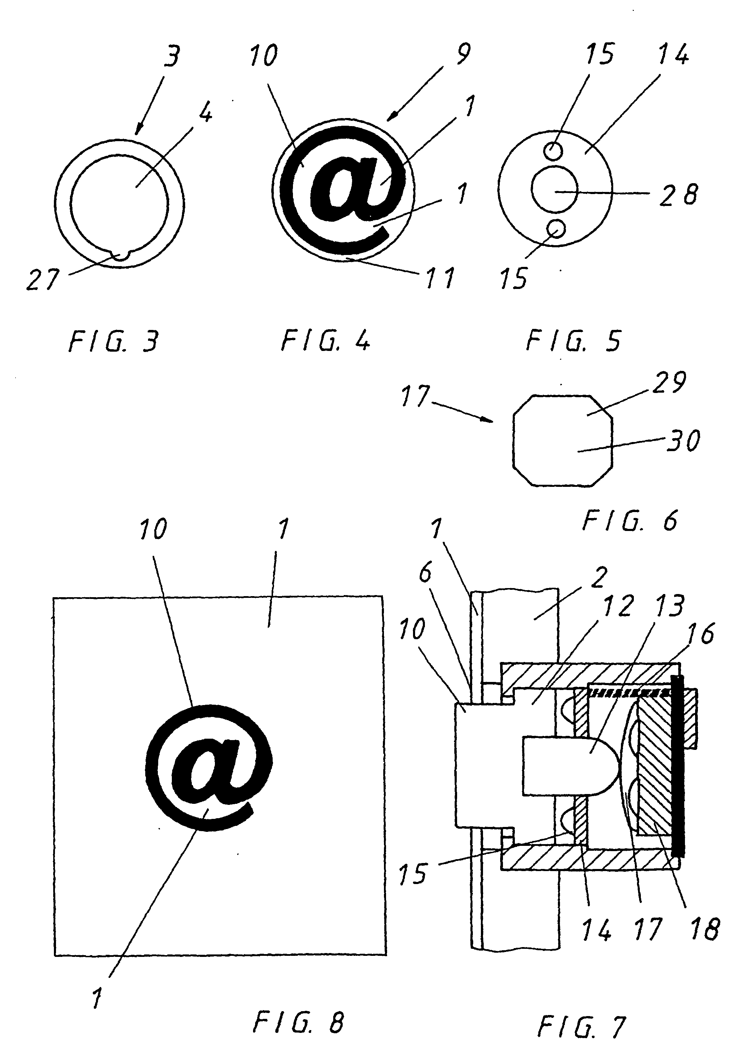

Dies führt zu einem optischen Eindruck, dergestalt, daß lediglich der dreidimensionale Symbolkörper 10 durch den entsprechenden Ausschnitt 5 hindurchgreift, wie dies beispielsweise in den Figuren 4 und 8 dargestellt ist.

Bei Druck auf diesen Symbolkörper 10 wird der Leuchtkörper 9 in Pfeilrichtung 41 betätigt.

Der Symbolkörper 10 ist bevorzugt werkstoffeinstückig aus dem Material des Leuchtkörpers 9 herausgefräst. Es ist natürlich auch möglich, den Symbolkörper 10 als getrenntes Element zum Leuchtkörper 9 auszubilden und diesen beispielsweise aufzukleben, zu spritzen oder in anderer Weise mit den übrigen Teilen des Leuchtkörpers 9 zu befestigen.

Der Symbolkörper 10 ist also in axialer Richtung mit entsprechenden Stegen 40 bis auf den Grund der Ringschulter 11 ausgefräst, wobei die Ringschulter 11 einen vergrößerten Durchmesser aufweist und einen kreiszylindrischen Ansatz 12 definiert.

Dieser kreiszylindrische Ansatz 12 mit der vorderen Ringschulter 11 schlägt an dem Ringanschlag 8 im Gehäuse 3 an.

An den Ansatz 12 vergrößerten Durchmessers schließt sich gemäß Figur 1 ein Druckstück 13 verkleinerten Durchmessers an, welches durch eine entsprechende Ausnehmung 28 in der Platine 14 hindurchgreift und auf einem gewölbten Boden 30 einer Schnappfeder 17 aufsitzt, die ihrerseits mittels eckseitig ausgebildeten Ansätzen 29 auf den Umfangsrändem des Piezosensors 18 aufliegt.

Wird also der Symbolkörper 10 durch eine entsprechende Betätigungskraft betätigt, dann bewegt er sich in Pfeilrichtung 41 in Richtung auf die Schnappfeder 17, drückt deren gewölbten Boden 30 durch, so daß dieser mit seinem gewölbten Boden 30 dann etwa im Mittelbereich auf dem Piezosensor 18 aufliegt und diesen schaltet, welcher Piezosensor 18 in Figur 2 näher dargestellt ist.

Gemäß Figur 2 ist auf einer Trägerplatte 19 hierbei ein Leitgummi 24 angeordnet, der vorderseitig ein Piezokristall 23 trägt.

Die gesamte Anordnung ist durch eine topfförmige Kunststoffkappe 22 abgedeckt, die mittels Zapfen 38 in zugeordnete Ausnehmungen der Trägerplatte 19 hindurchgreift und dort verankert ist.

Bei Druck der Schnappfeder 17 in Betätigungsrichtung 25 auf die Kunststoffkappe 22 wird somit das Piezokristall 23 verdichtet und gibt über den Leitgummi 24 eine entsprechende Piezospannung auf die auf der Platine 19 angeordneten Kontaktflächen 42.

Auf der Platine 19 sind noch zugeordnete Auswerteschaltungen angeordnet, welche das Piezoschaltsignal entsprechend verstärken und in ein entsprechendes auswertbares Signal umsetzen. Dieses wird über den an der Platine 19 angesetzten Stecker nach außen abgeleitet, welcher aus dem Steckerkörper 20 und den daran ansetzenden Steckerstiften 21 besteht.

Es ist nun gemäß Figur 1 vorgesehen, daß auf der Platine 14 eine Beleuchtung angeordnet ist, die im gezeigten Ausführungsbeispiel aus zwei diametral gegenüberliegenden LEDs 15 besteht, welche über eine Anschlußleitung 16 mit der Trägerplatte 19 verbunden sind.

Wichtig ist, daß nun die LEDs 15 ihr Licht in den Pfeilrichtungen 43 auf die gesamte Rückseite des Leuchtkörpers 9 verteilen, so daß das Licht sowohl auf das Druckstück 13, als auch auf den Ringansatz 12 einwirkt, so daß der Leuchtkörper 9 insgesamt vollflächig von hinten beleuchtet wird und im Sinne eines Lichtleiters das Licht sehr gleichmäßig verteilt auf den Symbolkörper 10 weiterleitet.

In Figur 1a ist schematisiert eine Explosionsdarstellung im Schnitt einer weiteren Ausführungsform eines Piezoschalters dargestellt, welcher ohne fingerförmiges Druckstück 13 des Leuchtkörpers 9 wie in Figur 1 gezeigt arbeitet.

Kern dieser Ausführungsform nach Figur 1a ist, dass der Leuchtkörper 9a etwa walzenförmig ausgebildet ist, und nicht scheibenförmig mit stiftförmigem Ansatz 13 wir in der Ausführung nach Figur 1. D. h. also, nach der Ausführung des Schalters der Figur 1, das fingerförmige Druckstück 13 des Leuchtkörpers 9 entfällt nun, und der neue Leuchtkörper 9a betätigt als Zylinderkörper selbst (ohne Zwischenschaltung eines derartigen Druckstückes) über eine Betätigungsplatte 47 das darunter bzw. dahinter angeordnete Schaltelement 46, welches Schaltelement ein Piezosensor sein kann.

Hierbei kann das Schaltelement 46 direkt auf der Platine 14, die auch die LEDs 15 trägt, angeordnet sein, wodurch erheblicher Einbauraum in der Tiefe eingespart wird. Der Schalter gemäß Figur 1a benötigt also eine wesentlich geringere Bautiefe, als der Schalter gemäß Figur 1, was insbesondere beim Einbau in Armaturenbrettern im Automobilbereich von Vorteil ist.

Das ausgesendete Licht der horizontal zum Lichtleiteelement angeordneten LEDs 15 (stehende LED bzw 90°-Typen) wird dann auch im wesentlichen horizontal in das Lichtleiteelement eingeleitet. Hierdurch wird bei erheblich geringerer Bauhöhe des Schalters eine sehr gute Lichtverteilung im Lichtleiteelement erreicht. Seite: 13 Die LEDs 15 befinden sich also im Vergleich zur Ausführung nach Figur 1 und nach dem Stand der Technik außerhalb - und nicht mehr unter- dem Leuchtkörper. Durch den flachen Aufbau des elektrischen Schaltelementes wird das Licht der stehend oder als 90° - Typen ausgeführten LEDs 15 seitlich, horizontal in den Leuchtkörper eingeleitet, was zu einer idealen Lichtverteilung bei gleichzeitig minimaler Bauhöhe führt.

Die in den Figuren 1 und 1a mit den gleichen Bezugszeichen versehenen Bauteile bezeichnen die gleichen Bauteile und werden daher an dieser Stelle nicht mehr beschrieben.

In den Figuren 3 bis 6 sind die Einzelheiten in Draufsicht verschiedener Teile dargestellt. Figur 3 zeigt hierbei die Stimansicht des Gehäuses 3, wobei ersichtlich ist, daß am Gehäuse noch eine axial verlaufende Nut 27 eingearbeitet ist, so daß die Anschlußleitungen 16 axial im Gehäuse entlanggeführt werden können.

Figur 4 zeigt, daß der Symbolkörper 10 beispielsweise als "@" ausgebildet sein kann. Dieser Symbolkörper 10 ist also lediglich von vorne her (von der Sichtseite der Deckplatte 1) sichtbar und leuchtet intensiv auf. Er ist gleichzeitig das Betätigungselement, weil nur auf diesen Symbolkörper die Betätigungskraft auf den Leuchtkörper 9 eingeleitet wird.

Damit ergibt sich eine völlig neue Betätigung und eine völlig neue Ansicht eines derartigen Schalters, weil nun durch Druck auf ein bestimmtes Symbol ein Schalter betätigt wird, was vorher nicht bekannt war.

Selbstverständlich ist die Erfindung hierauf nicht beschränkt; es kann auch vorgesehen sein, daß die Stege 26 im Bereich des Ausschnittes 5 entfallen, so daß also der Symbolkörper 10 mit seinem Symbolgrund im Bereich der Ringschulter 11 sichtbar ist, so daß also das vorstehende Symbol stärker leuchtet, als der zurückspringende Symbolgrund, der etwa auf der Höhe der Ringschulter 11 sitzt.

In einer dritten Ausführungsform kann es vorgesehen sein, daß der Symbolkörper 10 nicht aus dem Vollmaterial des Leuchtkörpers 9 herausgefräst ist, sondern daß ein Symbol auf die Stirnseite des Leuchtkörpers aufgeklebt ist und dann lediglich die Umgebung des Symbols leuchtet.

Die erstgenannte Ausführungsform wird jedoch als bevorzugte Ausführungsform angesehen.

Statt des Aufklebens eines flächigen Symbols können auch Symbolkörper aufgeklebt werden, die entweder auch flächig ausgebildet sind oder als dreidimensionale Körper ausgebildet sind. Statt dem Aufkleben können auch andere Verbindungsmechanismen gewählt werden, wie z. B. Anspritzen und/oder mechanisches Rasten und dergleichen mehr.

Durch die in Figur 5 dargestellte Ausnehmung 28 in der Platine 14 greift das Druckstück 13 des Leuchtkörpers 9 hindurch und sitzt dann auf der Schnappfeder 17 auf.

Figur 6 zeigt diese Schnappfeder 17, wobei erkennbar ist, daß ein etwa quadratisches Metallplättchen eckenseitige, abgeschrägte Ausklinkungen aufweist und somit Ansätze ausbildet, mit denen die Schnappfeder 17 in den Randbereichen der Kunststoffkappe 22 auf dieser aufliegt.

Die Schnappfeder 17 kann in beliebiger Weise im Zwischenraum zwischen der Kunststoffkappe 22 und der Platine 14 gehalten werden.

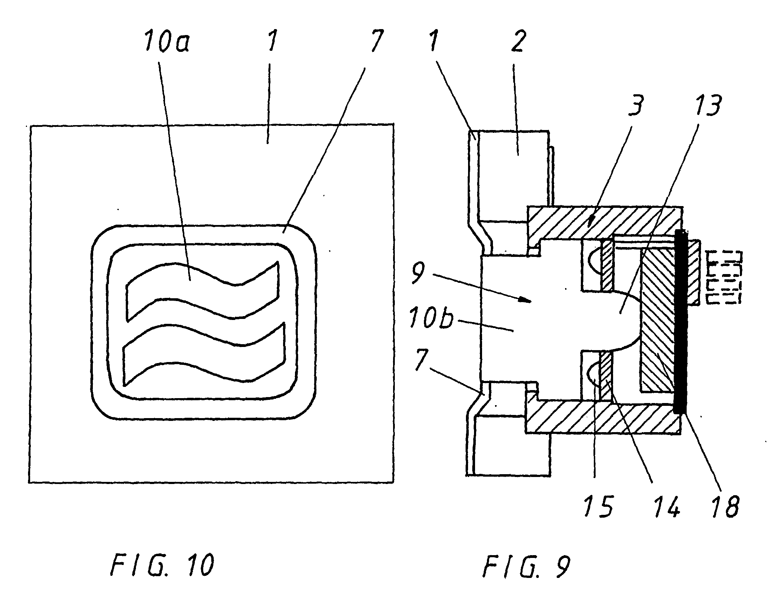

Figur 7 zeigt den zusammengebauten Zustand der Anordnung nach Figur 1, wobei lediglich noch dargestellt ist, daß der Rückversatz 7 im Bereich der Deckplatte 1 entfallen kann, so daß der Symbolkörper 10 über die Vorderfläche der Deckplatte 1 heraussteht, während er in Figur 1 bündig mit der Vorderfläche 6 ist oder hinter der Vorderfläche 6 zurückbleibt. Die Ausführungsform nach Figur 1 würde einen tiefer geprägten, umlaufenden Rand ergeben, so wie dies in Figur 10 dargestellt ist.

In Figur 8 entfällt dieser Rand, weil die Figur 8 die Stirnansicht der Darstellung nach Figur 7 ist, und es ist erkennbar, daß lediglich der Symbolkörper 10 durch entsprechende Durchbrechungen in der Deckplatte herausgreift und unmittelbar hierdurch betätigt wird.

Die Vorderkante des Symbolkörpers 10 muß jedoch stets - wenn auch nur geringfügig - über die Vorderkante des Ausschnittes 5 herausragen, um überhaupt ein - geringfügiges - Betätigungsspiel für den Leuchtkörper 9 zu gewährleisten.

Die Figuren 9 und 10 zeigen, daß die Schnappfeder 17 entfallen kann, so daß das Druckstück 13 unmittelbar auf dem Piezosensor 18 aufliegt.

Ebenso ist dargestellt, daß bei Anbringung eines Rücksprunges 7 ein umlaufender Rand im Bereich der Deckplatte 1 ausgebildet wird, in dessen Innenbereich nun der dreidimensionale Symbolkörper 10 aus entsprechenden Durchbrechungen des Ausschnittes 5 herausragt und intensiv und auffällig beleuchtet ist.

Der Umgebungsbereich des wellenförmigen Symbolkörpers 10a nach Figur 10 ist nämlich unbeleuchtet und aus dem Material der Deckplatte gebildet, so daß also nur dieses wellenförmige Symbol selbst auffällig leuchtet und als Betätigungselement für den Leuchtkörper 9 dient.

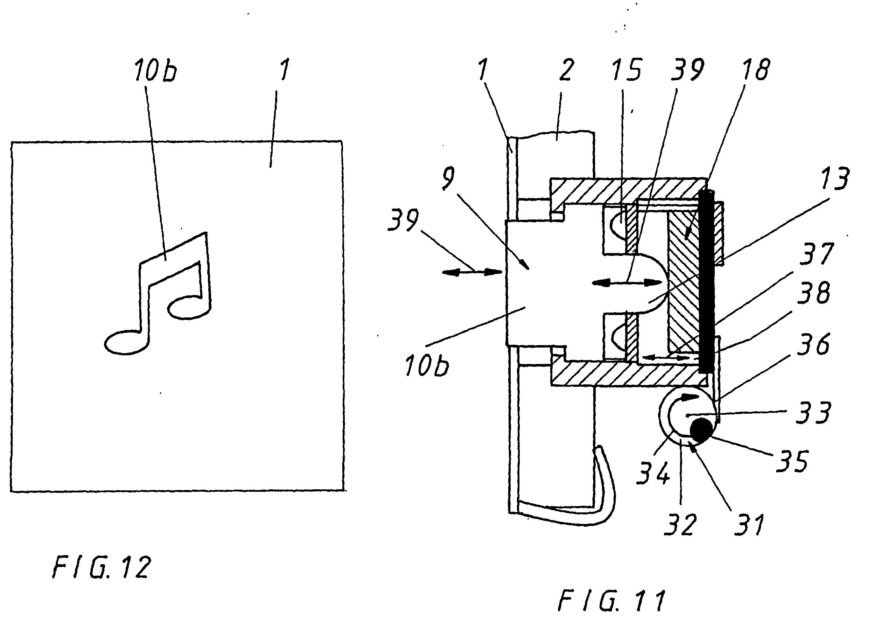

In den Figuren 11 und 12 ist als weitere Ausführungsform ein Piezoschalter dargestellt, der eine taktile Rückmeldung des Schaltvorganges in Form einer Vibration mitteilt.

Hier ist als weiteres Ausführungsbeispiel gemäß Figur 12 der Symbolkörper 10b als Musiknote ausgebildet, der intensiv beleuchtet aus der Deckplatte 1 herausragt und unmittelbar als Betätigungselement dient.

Es ist erkennbar, daß lediglich ein geringes Bewegungsspiel für die Betätigung des Leuchtkörpers 9 erforderlich ist, weil auch hier - wie beim Ausführungsbeispiel nach den Figuren 9 und 10 - die Schnappfeder 17 entfällt.

Wichtig bei diesem Ausführungsbeispiel ist, daß der Vibrator 31 in dem gezeigten Ausführungsbeispiel als Motor ausgebildet ist, der eine Scheibe 32 um ihre Drehachse 33 herum in Pfeilrichtung 34 antreibt.

Auf der Scheibe 32 ist ein zur Drehachse 33 exzentrisch versetztes Exzentergewicht 35 angeordnet.

Bei Auslösung eines Schaltvorganges wird damit der Motor beispielsweise für eine Schaltzeit von 120 ms eingeschaltet, und die drehangetriebene Scheibe 32 mit dem Exzentergewicht 35 bringt eine Unwucht über das Motorlager 36 auf die Zapfen 38 der Kunststoffkappe 22 des Piezosensors 18 (siehe Figur 2), so daß diese Vibrationskraft in Pfeilrichtung 37 auf der Kunststoffkappe übertragen wird, die ihrerseits vibriert und das kraftschlüssig darauf aufsitzende Druckstück 13 des Leuchtkörpers 9 anregt, der sich nun in den Pfeilrichtungen 39 bewegt.

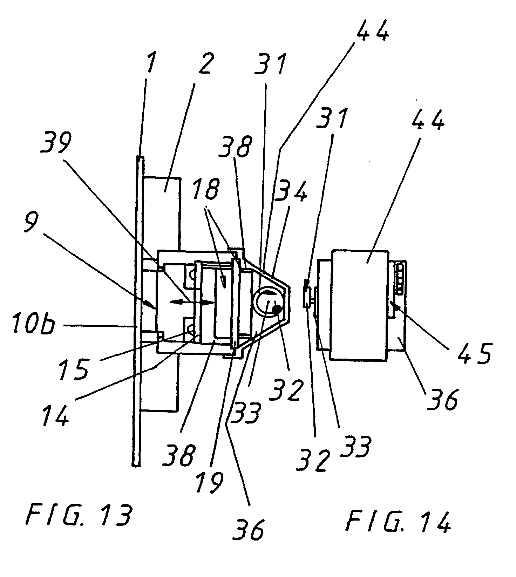

Gemäß Figur 13 ist eine andere Ausführungsform des Vibrators 31 und der Halterung des Vibrators 31 an dem Motorlager 36 gezeigt, wobei hier die Verbindung zu den Zapfen 38 über eine entsprechend geformte Schelle 44 dargestellt ist. In diese Schelle 44 ist nun der Motor 45 über das Motorlager 36 eingebettet, wobei sich die Schelle 44 am Außenumfang des Gehäuses 3 festklammert. Im Unterschied zu Figur 11 ist die Scheibe 32 nicht zentrisch gelagert und besitzt kein exzentrisches Exzentergewicht 35, sondern die Scheibe 32 selbst ist exzentrisch auf der Drehachse 33 gelagert und bildet somit eine Unwucht bei Rotation in Pfeilrichtung 34, oder auch in Gegenrichtung hierzu.

In Figur 14 ist noch eine gegenüber Figur 13 um 90° gedrehte Seitenansicht des Vibrators 31 mit Motor 45 gezeigt, wobei die exzentrische Lagerung des Exzentergewichtes 35 hier gut zu sehen ist. Rotiert nun das Exzentergewicht 35 um die Drehachse 33, werden die exzentrischen Schwingungen in den Pfeilrichtungen 39 (Fig. 13) auf das Motorlager 36 übertragen, von dort aus auf die Schelle 44 und/oder die Zapfen 38 und von dort auf das Gehäuse 3 und somit auf den Leuchtkörper 9 bzw. den Symbolkörper 10, wo der Benutzer die Schwingungen taktil mit dem Finger aufnehmen kann.

Im übrigen sieht die Erfindung vor, daß der Schalter mindestens teilweise hermetisch vergossen wird, um ihn gegen Einwirkung von Feuchtigkeit zu schützen. In einer anderen Ausgestaltung kann er aber auch in offener Bauweise ausgeführt werden.

Es wird nochmals wiederholt, daß die taktile Rückmeldung durch Anordnung eines Vibrators 31 unabhängigen Schutz genießen soll, unabhängig davon, ob der Schalter nun beleuchtet ist oder nicht.

### Zeichnungslegende

- 1: Deckplatte
- 2: Träger
- 3: Gehäuse
- 4: Hohlraum
- 5: Ausschnitt
- 6: Vorderfläche
- 7: Rückversatz
- 8: Ringanschlag
- 9: Leuchtkörper
- 10: Symbolkörper 10a, b
- 11: Ringschulter
- 12: Ansatz
- 13: Druckstück
- 14: Platine
- 15: LED
- 16: Anschlußleitung
- 17: Schnappfeder
- 18: Piezosensor
- 19: Trägerplatte
- 20: Steckerkörper
- 21: Steckerstifte
- 22: Kunststoffkappe
- 23: Piezokristall
- 24: Leitgummi
- 25: Betätigungsrichtung
- 26: Stege
- 27: Nut
- 28: Ausnehmung
- 29: Ansatz
- 30: gewölbter Boden
- 31: Vibrator
- 32: Scheibe
- 33: Drehachse
- 34: Pfeilrichtung
- 35: Exzentergewicht
- 36: Motorlager
- 37: Pfeilrichtung
- 38: Zapfen
- 39: Pfeilrichtungen
- 40: Symbolstege
- 41: Pfeilrichtung
- 42: Kontaktfläche
- 43: Pfeilrichtung
- 44: Schelle
- 45: Motor
- 46: Schaltelement
- 47: Betätigungsplatte

## Patentansprüche

1. Elektrischer Schalter, insbesondere Piezoschalter, beinhaltend mindestens ein Schaltelement (18) unterhalb einer Deckplatte (1), welches mittels eines, einen Ausschnitt (5) der Deckplatte (1) durchgreifenden Betätigungselementes betätigt werden kann, wodurch ein Schaltsignal erzeugt und Ober elektrische Kontakte ausgeleitet wird, wobei das Betätigungselement selbst als passiver Leuchtkörper (9) aus einem transluzenten oder transparenten Material ausgebildet ist, und über aktive Leuchtmittel (15) beleuchtbar ist und wobei die Betätigungsfläche des Leuchtkörpers (9) als dreidimensional ausgestalteter Symbolkörper (10) mit die Formgebung des Symbols definierenden Symbolstegen (40) ausgebildet ist, **dadurch gekennzeichnet, daß** der Ausschnitt (5) der Deckplatte (1) Deckplattendurchbrechungen und Deckplattenstege (26) aufweist, wobei lediglich die Symbolstege (40) des Symbolkörpers (10) durch die Deckplattendurchbrechungen hindurchgreifen, und die übrigen Teile des Symbolkörpers (10) durch die Deckplattenstege (26) der Deckplatte (1) verdeckt sind.

2. Elektrischer Schalter nach Anspruch 1, **dadurch gekennzeichnet, daß** das Material des Leuchtkörpers (9) aus Kunststoff ist.

3. Elektrischer Schalter nach einem der Ansprüche 1 oder 2, **dadurch gekennzeichnet, daß** das Material der Deckplatte (1) aus Holz, Metall, Kunststoff oder Glas ist.

4. Elektrischer Schalter nach einem der Ansprüche 1 bis 3, **dadurch gekennzeichnet, daß** die Deckplatte (1) im Bereich des Ausschnitts (5) im Bezug auf die Vorderfläche (6) einen Rückversatz (7) als Fingermulde aufweist.

5. Elektrischer Schalter nach einem der Ansprüche 1 bis 4, **dadurch gekennzeichnet, daß** der Symbolkörper (10) lediglich von vorne her, also von der Sichtseite der Deckplatte (1) her, für den Benutzer sichtbar ist.

6. Elektrischer Schalter nach einem der Ansprüche 1 bis 5, **dadurch gekennzeichnet, daß** der Schalter mindestens teilweise hermetisch vergossen ist, um ihn gegen Einwirkung von Feuchtigkeit zu schützen.

7. Elektrischer Schalter nach einem der Ansprüche 1 bis 6, **dadurch gekennzeichnet, daß** der Symbolkörper (10) werkstoffeinstückig aus dem Material des Leuchtkörpers (9) herausgefräst ist oder als getrenntes Element zum Leuchtkörper (9) ausgebildet ist und auf diesen aufgebracht ist.

8. Elektrischer Schalter nach Anspruch 7, **dadurch gekennzeichnet, daß** der Symbolkörper (10) als getrenntes Element zum Leuchtkörper (9) ausgebildet ist und auf diesen aufgeklebt oder aufgespritzt ist.

9. Elektrischer Schalter nach einem der Ansprüche 1 bis 8, **dadurch gekennzeichnet, daß** eine optische Rückmeldung des Schaltvorganges durch Ein-/Ausschalten der Leuchtmittel (15) erfolgt.

10. Elektrischer Schalter nach Anspruch 9, **dadurch gekennzeichnet, daß** die Leuchtmittel (15) gebildet werden durch mindestens eine einfarbige LED oder durch mehrere verschiedenfarbige LED, welche unabhängig voneinander betreibbar sind.

11. Elektrischer Schalter nach einem der Ansprüche 1 bis 10, **dadurch gekennzeichnet, daß** eine mechanische Rückmeldung des Schaltvorganges über eine Schnappfeder (17) bewerkstelligt wird, welche im wesentlichen zwischen Leuchtkörper (9) und Schaltelement (18) angeordnet ist.

12. Elektrischer Schalter nach einem der Ansprüche 1 bis 10, **dadurch gekennzeichnet, daß** eine mechanische Rückmeldung des Schaltvorganges über einen Vibrator (31) erfolgt, der aufgrund des eingeleiteten Schaltvorganges betätigt wird und der eine vibrierende Bewegung auf den Leuchtkörper (9) abgibt.

13. Elektrischer Schalter nach Anspruch 12, **dadurch gekennzeichnet, daß** der Vibrator (31) als Miniaturmotor (45) ausgebildet ist.

14. Elektrischer Schalter nach Anspruch 13, **dadurch gekennzeichnet, daß** der Miniaturmotor (45) eine Scheibe (32) antreibt, welche exzentrisch auf einer Drehachse (33) gelagert ist, oder welche Scheibe (32) zentrisch gelagert ist und ein exzentrisches Exzentergewicht (35) aufweist, und somit die Vibrationen des Vibrators (31) über das Motorlager (36) auf den Leuchtkörper (9) geleitet werden.

15. Elektrischer Schalter nach Anspruch 12, **dadurch gekennzeichnet, daß** der Vibrator (31) als Wagner'scher Hammer oder Elektromagnet oder Ultraschall-Element ausgebildet ist.

16. Elektrischer Schalter nach Anspruch 12, **dadurch gekennzeichnet, daß** der Vibrator (31) durch einen Piezosensor gebildet wird, der als aktiver Piezokristall ausgebildet ist.

17. Elektrischer Schalter nach Anspruch 12, **dadurch gekennzeichnet, daß** bei Ausbildung des elektrischen Schalters als Piezoschalter der Vibrator (31) durch mindestens einen Piezosensor (18) des Piezoschalters gebildet wird.

## Claims

1. Electric switch, in particular a piezoelectric switch, containing underneath a cover plate (1) at least one switch element (18) that can be actuated by means of an actuating element reaching through a cutout (5) in the cover plate (1), thus generating a switching signal which is led out via electrical contacts, the actuating element itself being configured as a passive luminous element (9) of translucent or transparent material lightable by active lighting means (15), and the actuating face of the luminous element (9) being configured as a three-dimensional symbol block (10) with symbol lands (40) defining the shape of the symbol, **characterized in that** the cutout (5) in the cover plate (1) has through openings and lands (26) such that only the symbol lands (40) of the symbol block (10) reach through the openings in the cover plate and the remaining parts of the symbol block (10) are concealed by the lands (26) of the cover plate (1).

2. Electric switch according to Claim 1, **characterized in that** the luminous element (9) is made of plastic material.

3. Electric switch according to Claim 1 or Claim 2, **characterized in that** the cover plate (1) is made of wood, metal, plastic material, or glass.

4. Electric switch according to any one of Claims 1 to 3, **characterized in that** the cover plate (1) has a recessed zone (7) set back from the front face (6) as a finger recess in the region of the cutout (5).

5. Electric switch according to any one of Claims 1 to 4, **characterized in that** the symbol block (10) is visible to the user only from in front, that is from the face side of the cover plate (1).

6. Electric switch according to any one of Claims 1 to 5, **characterized in that** the switch is at least partly sealed-in to protect it from the action of moisture.

7. Electric switch according to any one of Claims 1 to 6, **characterized in that** the symbol block (10) is machined out of the material of the luminous element (9) as one piece, or is formed as a separate element from the luminous element (9) and is affixed thereto.

8. Electric switch according to Claim 7, **characterized in that** the symbol block (10) is formed as a separate element from the luminous element (9) and is glued or injection-moulded thereon.

9. Electric switch according to any one of Claims 1 to 8, **characterized in that** a visual confirmation of the switching operation is given by the switching on or off of the lighting means (15).

10. Electric switch according to Claim 9, **characterized in that** the lighting means (15) consist of at least one single-colour LED or a plurality of LEDs of various colours that can be operated independently of each other.

11. Electric switch according to any one of Claims 1 to 10, **characterized in that** a mechanical confirmation of the switching operation is provided by a snap spring (17) which is arranged substantially between the luminous element (9) and the switch element (18).

12. Electric switch according to any one of Claims 1 to 10, **characterized in that** a mechanical confirmation of the switching operation is given by a vibrator (31) which is actuated as a result of the switching operation which has been initiated and imparts a vibrating motion to the luminous element (9).

13. Electric switch according to Claim 12, **characterized in that** the vibrator (31) is configured as a miniature motor (45).

14. Electric switch according to Claim 13, **characterized in that** the miniature motor (45) drives a disc (32) which is mounted eccentrically on a rotational axis (33) or is mounted centrally and has an eccentric weight (35), so that the vibrations of the vibrator (31) are transmitted through the motor mounting (36) to the luminous element (9).

15. Electric switch according to Claim 12, **characterized in that** the vibrator (31) is configured as a hammer interrupter or electromagnet or ultrasonic element.

16. Electric switch according to Claim 12, **characterized in that** the vibrator (31) is formed by a piezoelectric sensor configured as an active piezoelectric crystal.

17. Electric switch according to Claim 12, **characterized in that** if the electric switch is configured as a piezoelectric switch, the vibrator (31) is formed by at least one piezoelectric sensor (18) of the piezoelectric switch.

## Revendications

1. Interrupteur électrique, notamment interrupteur piézoélectrique, contenant au moins un élément de commutation (18), situé au-dessous d'une plaque de recouvrement (1), qui peut être actionné à l'aide d'un élément d'actionnement traversant une partie découpée (5) de la plaque de recouvrement (1), moyennant quoi un signal de commutation est généré et est acheminé par l'intermédiaire de contacts électriques, étant précisé que l'élément d'actionnement lui-même est conçu comme un corps lumineux passif (9) en matière translucide ou transparente et est apte à être éclairé grâce à des moyens lumineux actifs (15), et que la surface d'actionnement du corps lumineux (9) est conçue comme un corps de symbole à trois dimensions (10) avec des pattes de symbole (40) qui définissent la forme du symbole, **caractérisé en ce que** la partie découpée (5) de la plaque de recouvrement (1) présente des interruptions de plaque de recouvrement et des bandes de plaque de recouvrement (26), seules les pattes de symbole (40) du corps de symbole (10) passant à travers lesdites interruptions tandis que les autres parties du corps de symbole (10) sont couvertes par lesdites bandes (26) de la plaque de recouvrement (1).

2. Interrupteur électrique selon la revendication 1, **caractérisé en ce que** la matière du corps lumineux (9) est constituée par une matière plastique.

3. Interrupteur électrique selon la revendication 1 ou 2, **caractérisé en ce que** la matière de la plaque de recouvrement (1) est constituée par du bois, du métal, une matière plastique ou du verre.

4. Interrupteur électrique selon l'une des revendications 1 à 3, **caractérisé en ce que** la plaque de recouvrement (1) présente dans la zone de sa partie découpée (5) une partie en retrait (7) par rapport à la surface avant (6), comme creux pour le doigt.

5. Interrupteur électrique selon l'une des revendications 1 à 4, **caractérisé en ce que** le corps de symbole (10) n'est visible par l'utilisateur que de devant, c'est-à-dire du côté visible de la plaque de recouvrement (1).

6. Interrupteur électrique selon l'une des revendications 1 à 5, **caractérisé en ce qu'**il est scellé de manière au moins partiellement hermétique afin d'être protégé de l'effet de l'humidité.

7. Interrupteur électrique selon l'une des revendications 1 à 6, **caractérisé en ce que** le corps de symbole (10) est fraisé d'une seule pièce dans la matière du corps lumineux (9) ou est conçu comme un élément séparé du corps lumineux (9) ou est posé sur celui-ci.

8. Interrupteur électrique selon la revendication 7, **caractérisé en ce que** le corps de symbole (10) est conçu comme un élément séparé du corps lumineux (9) et est collé ou injecté sur celui-ci.

9. Interrupteur électrique selon l'une des revendications 1 à 8, **caractérisé en ce qu'**un accusé de réception optique de la manoeuvre a lieu grâce à la mise en circuit/hors circuit des moyens lumineux (15).

10. Interrupteur électrique selon la revendication 9, **caractérisé en ce que** les moyens lumineux (15) sont formés par au moins une diode lumineuse à une couleur ou par plusieurs diodes lumineuses de différentes couleurs qui sont aptes à fonctionner indépendamment les unes des autres.

11. Interrupteur électrique selon l'une des revendications 1 à 10, **caractérisé en ce qu'**un accusé de réception mécanique de la manoeuvre est réalisé grâce à un ressort à déclic (17) qui est disposé globalement entre le corps lumineux (9) et l'élément de commutation (18).

12. Interrupteur électrique selon l'une des revendications 1 à 10, **caractérisé en ce qu'**un accusé de réception mécanique de la manoeuvre a lieu grâce à un vibreur (31) qui est actionné en raison de la manoeuvre et qui produit un mouvement vibrant sur le corps lumineux (9).

13. Interrupteur électrique selon la revendication 12, **caractérisé en ce que** le vibreur (31) est conçu comme un moteur miniature (45).

14. Interrupteur électrique selon la revendication 13, **caractérisé en ce que** le moteur miniature (45) entraîne une plaque (32) qui est montée de manière excentrée sur un axe de rotation (33) ou qui est montée de manière centrée et qui comporte un poids d'excentrique excentré (35), et les vibrations du vibreur (31) sont ainsi transmises au corps lumineux (9) par l'intermédiaire du palier de moteur (36).

15. Interrupteur électrique selon la revendication 12, **caractérisé en ce que** le vibreur (31) est conçu comme un rupteur ou comme un électro-aimant ou comme un élément à ultrasons.

16. Interrupteur électrique selon la revendication 12, **caractérisé en ce que** le vibreur (31) est formé par un capteur piézoélectrique qui est conçu comme un cristal piézoélectrique actif.

17. Interrupteur électrique selon la revendication 12, **caractérisé en ce que** s'il est conçu comme un interrupteur piézoélectrique, le vibreur (31) est formé par au moins un capteur piézoélectrique (18) de l'interrupteur piézoélectrique.
